# FASCICULE DE BREVET EUROPEEN

(11) **EP 0 861 511 B1**
(45) Date de publication et mention de la délivrance du brevet: **01.09.1999**
(21) Numéro de dépôt: 96938289.4
(22) Date de dépôt: 08.11.1996
(51) Int. Cl.: H01S 3/043, H01S 3/25

(54) **ASSEMBLAGE DE BARRETTES DE DIODES LASER REFROIDIES**
BAUGRUPPE FÜR GEKÜHLTE LASERDIODENREIHE
COOLED LASER DIODE ARRAY ASSEMBLY

(30) Priorité: 13.11.1995 FR 9513400
(43) Date de publication de la demande: 02.09.1998
(73) Titulaire: COMMISSARIAT A L'ENERGIE ATOMIQUE, 75015 Paris Cédex 15 (FR); COMPAGNIE GENERALE DES MATIERES NUCLEAIRES (COGEMA), 78141 Velizy-Villacoublay (FR)
(72) Inventeur: LE GARREC, Bruno, F-91940 Les-Ulis (FR); RAZE, Gérard, F-91940 Les-Ulis (FR)
(74) Mandataire: Signore, Robert
(86) Numéro de dépôt international: FR9601772
(87) Numéro de publication internationale: WO9718606

(56) Documents cités:
- US-A- 4 315 225
- US-A- 5 031 184
- IEEE JOURNAL OF QUANTUM ELECTRONICS, vol. 28, no. 4, 1 Avril 1992, pages 992-996, XP000272690 COMASKEY B J ET AL: "HIGH AVERAGE POWER DIODE PUMPED SLAB LASER"

## Description

### Domaine technique

L'invention concerne le domaine des assemblages de barrettes de diodes laser et leurs systèmes de refroidissement.

Les domaines d'application des assemblages de barrettes de diodes laser sont nombreux et peuvent être regroupés en deux grandes familles :
- les applications où le rayonnement laser des diodes est utilisé directement (faisceau mis en forme par des optiques ou véhiculé par des fibres) ; ces applications concernent essentiellement :
   * le domaine médical
   * le domaine industriel (marquage),
- les applications où le rayonnement laser des diodes est utilisé pour le pompage optique des milieux laser (milieux à stockage d'énergie ou milieux à effet non linéaire) ; il s'agit, par exemple :
   * du pompage optique de matériaux cristallins, tels que les oxydes ou les fluorures dopés avec des ions de terres rares (Nd, Er, Tm, Ho, Yb, Pr, Ce,...) ou des ions Cr, Co,... etc.,
   * du pompage optique de matériau laser, tels que des colorants,
   * de l'interaction avec des milieux à effets non linéaires (génération d'harmoniques, oscillateurs ou amplificateurs paramétriques).

### Etat de la technique

Les barrettes de diodes laser et, de façon plus générale, les diodes laser, ont un rendement optique/électrique de l'ordre de 25 à 33%. Par conséquent, la puissance perdue par échauffement représente de 66 à 75% de la puissance électrique consommée. Dans une barrette continue de 20 watts, le volume actif (semi-conducteur) est en général très petit (dimensions micrométriques), typiquement de 0,5 à 1 mm³, et la densité de puissance thermique est comprise entre 60 et 160 kW/cm³. La barrette est en général soudée sur une embase (en laiton ou en cuivre) qui a plusieurs rôles :
- un rôle de support mécanique rigide,
- un rôle de liaison électrique (anode),
- un rôle thermique, du fait d'une conductivité thermique élevée.

Dans toutes les barrettes de diodes laser commerciales, la conduction thermique se fait par le bas, par le substrat, l'embase anode en général. Cette embase doit être au contact d'une source froide afin d'évacuer la puissance thermique et de limiter l'élévation de température dans le semi-conducteur. La connexion en partie haute (cathode) ne peut en général pas assurer une conductivité thermique suffisante et l'échange thermique se fait par convection naturelle de l'air ambiant.

Pour créer une source froide, on peut utiliser soit une boîte à eau en métal (laiton ou cuivre), soit un thermoélément à effet Peltier.

Ces techniques supposent un bon contact entre l'embase de la barrette et la source froide, afin de minimiser la résistivité thermique de contact. La technologie à effet Peltier est très utilisée dans les applications à faible puissance, et lorsque le nombre de diodes est limité. Il n'y a pas d'exemple d'utilisation de cette technologie pour les barrettes continues de puissance (typiquement 20 Watts moyens).

Une technologie dite "à microcanaux" est décrite dans les documents US-5 105 429 et US-5 105 430. Cette technologie repose sur l'assemblage de modules entre eux, pour former une structure émettrice à deux dimensions, chaque module comportant une barrette de diode disposée sur un substrat à refroidissement de microcanaux.

Des améliorations ou variantes ont été réalisées, portant sur l'architecture interne de la structure, la constitution des empilements ou sur la façon de faire circuler le fluide de refroidissement. Le principe du refroidissement par structure à microcanaux reste le même : on bénéficie d'une grande surface d'échange (radiateur) en réalisant un réseau d'ailettes dans un matériau conducteur. Le matériau peut être le semi-conducteur lui-même ou un matériau ayant une bonne conduction thermique, tel le silicium, le cuivre ou le diamant.

Le radiateur à microcanaux peut être intégré à chaque embase de barrette afin d'avoir un module autonome, ou bien être commun à des assemblages de barrettes (assemblage à deux dimensions ou surfacique).

Le champ d'application de la technologie "à microcanaux" est celui des empilements de barrettes. Des empilements de barrettes de 1 cm de large, ou plus, permettent de réaliser des zones émissives de plusieurs centimètres carrés. C'est l'alternative la plus répandue aux réseaux de diodes à émission surfacique. Le développement de la technique à microcanaux est très délicat pour les raisons suivantes.

Tout d'abord, cette technique à microcanaux n'est accessible que par des technologies de gravure très sophistiquées. Ensuite, la taille des canaux est en général de l'ordre de la centaine de microns, avec un espacement de 50 à 150 microns. Le liquide de refroidissement doit donc être filtré avec soin pour éviter de boucher le réseau de microcanaux. Il en résulte une perte de charge élevée qui, pour des débits de fluides raisonnables, de l'ordre du litre par minute, supposent des pressions élevées (supérieures à 4 bars).

Enfin, dans le cas du pompage optique, les empilements connus de barrettes à microcanaux ne permettent pas de pomper des milieux ayant par exemple une forme cylindrique.

Une technologie plus classique consiste à monter des barrettes en empilement, et à les refroidir par l'arrière au contact d'une boîte à eau. Cette technologie n'est envisageable que pour des barrettes à émission quasi-continue, c'est-à-dire pour des puissances moyennes, par barrettes, de 1 à 4 Watts, et reste la solution proposée sur les produits commerciaux.

Le document US-5 031 184 décrit un dispositif de refroidissement de diodes de pompage à semi-conducteurs. La structure de ce dispositif est complexe puisqu'elle fait intervenir un montage sur des éléments à effet Peltier, qui reposent eux-mêmes sur une embase. Aucune indication n'est donnée concernant le montage de l'ensemble, et en particulier le maintien des pièces et des joints par rapport à l'embase.

Dans un tel dispositif, il semble difficile de pouvoir garantir l'étanchéité et la rigidité mécanique de l'ensemble, d'autant plus qu'un positionnement à la fois par le dessous et les deux côtés n'est pas facile à réaliser. En outre, les dilatations thermiques risquent de provoquer des contraintes mécaniques difficiles à contenir dans un tel montage.

Du point de vue thermique il semble très difficile, avec le dispositif décrit dans US-5 031 184 de pouvoir régler finement la température des semi-conducteurs par l'intermédiaire des éléments Peltier quand ceux-ci sont pris en sandwich entre deux systèmes de refroidissement à eau dont le principe est d'assurer une bonne évacuation thermique grâce à un bon coefficient d'échange thermique. Si à la rigueur ce principe peut être utilisé pour un seul élément, il ne peut l'être pour deux, car l'effet du premier élément Peltier aurait une conséquence sur le deuxième élément, obligeant le second Peltier à compenser ce défaut ce qui entraîne les mêmes conséquences sur le troisième composant, etc.

### Exposé de l'invention

L'objet de l'invention est de proposer un montage linéaire modulaire de barrettes de diode laser intégrant le système de refroidissement, nécessaire d'une part à l'évacuation de la puissance thermique dissipée par les barrettes, et d'autre part à la thermostatation des émetteurs, c'est-à-dire à la stabilité de la longueur d'onde d'émission des diodes.

A cette fin, l'invention a pour objet un assemblage de N barrettes de diodes laser, dans lequel :
- chaque diode est montée à l'extrémité d'une embase formant anode, traversée par un trou, l'ensemble des trous définissant un canal de circulation d'un fluide de refroidissement de l'assemblage linéaire de barrettes de diodes, chaque module, constitué d'une barrette, de l'embase et d'une cathode correspondantes, étant séparé de chaque module immédiatement voisin par un joint plat,
- chaque embase étant munie d'un second trou, l'ensemble des seconds trous étant aligné lorsque les barrettes sont disposées côte à côte en position de fonctionnement,
- deux brides de maintien étant disposées aux extrémités de l'assemblage linéaire de barrettes, ces brides étant serrées par une vis qui traverse l'assemblage par l'ensemble des seconds trous.

Ce dispositif permet d'intégrer au mieux les fonctions mécanique et thermique.

Selon l'invention, on peut donc assurer un assemblage en ligne de diodes laser et, simultanément, un refroidissement direct de l'embase permettant de diminuer la résistance thermique du montage. Le refroidissement permet, d'une part, d'évacuer la puissance thermique dissipée par les barrettes et, d'autre part, de stabiliser la longueur d'onde d'émission des diodes. La présence d'un joint plat entre deux modules immédiatement voisins permet d'assurer l'étanchéité au fluide de refroidissement, mais aussi l'indépendance électrique des modules entre eux.

Un tel dispositif ou assemblage linéaire permet le pompage de milieux lasers ayant une forme allongée ou cylindrique.

Deux brides de maintien sont disposées aux extrémités de l'assemblage linéaire de barrettes, et des moyens de fixation (ensemble des seconds trous et vis) permettent d'assurer la tenue mécanique de l'ensemble, la vis permettant de serrer les brides. Cette vis traverse l'assemblage et peut être recouverte, à sa périphérie, d'une gaine isolante.

Des moyens de connexion électrique peuvent être prévus pour l'alimentation des barrettes de diode.

Une alimentation de type série peut par exemple être prévue, dans laquelle l'anode associée à chaque barrette est reliée à la cathode d'une barrette voisine.

### Brève description des figures

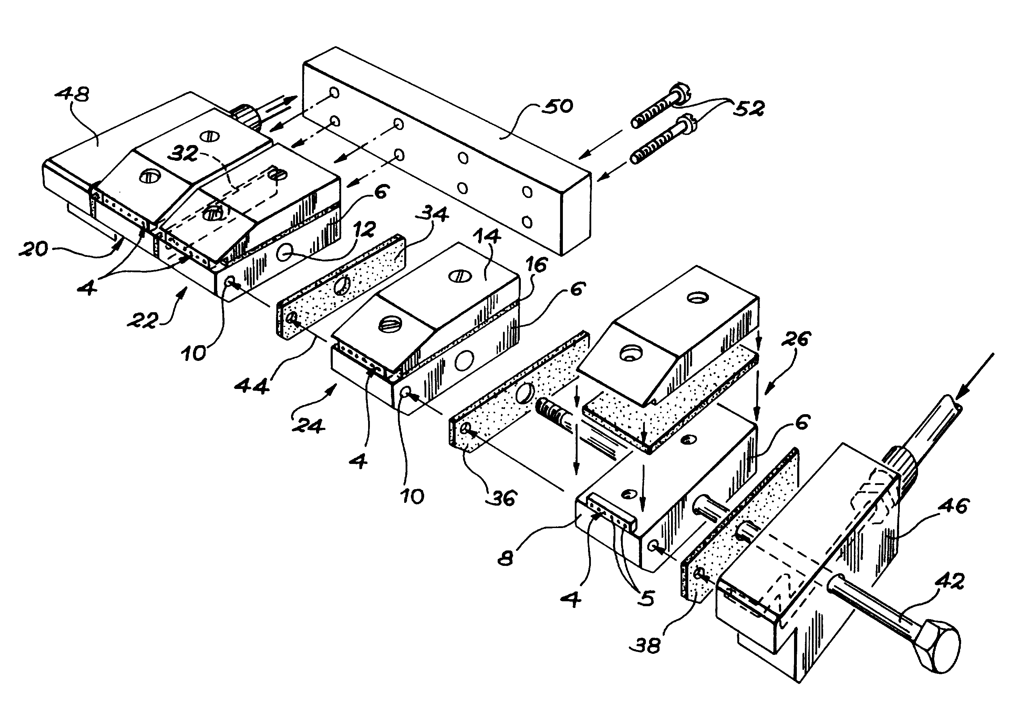

De toute façon, les caractéristiques et avantages de l'invention apparaîtront mieux à la lumière de la description qui va suivre. Cette description porte sur les exemples de réalisation, donnés à titre explicatif et non limitatif, en se référant à la figure unique annexée, qui représente un assemblage de barrettes de diodes selon l'invention.

### Description détaillée de modes de réalisation de l'invention

La figure unique illustre une réalisation d'un montage linéaire modulaire de barrettes de diodes laser, intégrant le système de refroidissement. L'ensemble est réalisé à partir de pièces identiques (module unitaire), assemblées côte à côte (assemblage linéaire).

Chaque barrette 4 de diodes laser (de dimensions typiques : largeur de 1 cm, profondeur de 0,5 à 0,6 mm, hauteur de 0,1 à 0,2 mm) est montée soudée sur une embase 6, qui est en fait ici une embase-anode, dont la largeur est légèrement supérieure à celle de la barrette. L'embase est en métal, par exemple en cuivre ou en laiton, éventuellement recouvert, par dépôt électrolytique, d'un revêtement d'or et de nickel permettant un soudage par brasage. L'émission à partir de chaque barrette se fait au niveau des jonctions (entre semi-conducteurs) 5, rassemblées par paquets et dont les dimensions sont de l'ordre de quelques micromètres à quelques dizaines de micromètres.

La barrette 4 est montée à une des extrémités 8 de l'embase 6. Cette dernière est munie de deux trous 10, 12 la traversant de part en part suivant sa largeur. Le premier trou 10 est situé le plus près possible de l'emplacement de la barrette 4 de manière à assurer un bon échange thermique entre la barrette et le fluide de refroidissement. Il sert à la circulation du fluide de refroidissement. Ce premier trou 10 a, par exemple, un diamètre de 2 mm, en étant situé à moins de 2,5 mm de la barrette 4, ce qui permet d'assurer un bon échange thermique. L'échange thermique est du type convection forcée, par fluide en mode turbulent. En fait, le diamètre du trou 10 et le débit du fluide sont de préférence déterminés de manière à optimiser les pertes de charge. De préférence, on fait circuler le fluide de manière à optimiser les pertes de charge.

Le second trou 12, par exemple de diamètre 5,2 mm, en position centrale, permet le passage d'une vis assurant le maintien des modules entre eux.

A chaque anode 6 correspond une cathode 14 et un isolant 16, situé entre cathode et anode.

Sur la figure des modules unitaires identiques 20, 22, 24, 26 sont disposés linéairement, côte à côte. Chaque module est séparé de chaque module voisin par un joint 32, 34, 36, 38. Dans chaque joint, des trous correspondant aux trous 10, 12, pratiqués dans chaque embase, permettent de laisser le passage libre pour la circulation d'un fluide de refroidissement, et pour des moyens de fixation 42, qui permettent d'assurer le maintien de l'ensemble. L'isolation électrique entre cathodes voisines est réalisée par le fait que les cathodes sont plus étroites que les anodes.

Les joints assurent d'une part l'isolation électrique des barrettes entre elles et, d'autre part, l'étanchéité du montage vis-à-vis du fluide de refroidissement, dont la circulation est désignée, sur la figure, par la flèche portant la référence 44.

Le fluide traverse tous les modules unitaires de la même manière, le montage assurant automatiquement la circulation du fluide à travers la succession d'embases et de joints.

L'ensemble est maintenu par ses extrémités grâce à deux brides 46, 48 qui servent de connexion d'entrée et de sortie au fluide de refroidissement. Ces deux brides sont maintenues solidaires de l'ensemble par les mêmes moyens de fixation 42 qui assurent le maintien des modules entre eux. Dans l'exemple donné, les brides sont serrées par une vis 42 qui traverse le montage. Cette vis est, à sa périphérie, recouverte d'une gaine isolante afin d'assurer l'isolation électrique des modules entre eux.

Dans le montage linéaire selon l'invention, les barrettes de diode peuvent être alimentées électriquement indépendamment l'une de l'autre.

Différents types de connexion électriques sont donc envisageables, en particulier une alimentation de type tout série où l'anode de chaque barrette (l'embase) est reliée à la cathode de sa voisine. Quelle que soit la solution retenue, elle peut être mise en oeuvre par l'intermédiaire d'un connecteur 50 monté en face arrière de l'assemblage. Ce connecteur peut être constitué d'un matériau isolant (par exemple Delrin ou Lucoflex), sur lequel sont rapportés des connecteurs métalliques de dimension et forme adaptées au montage désiré et au courant véhiculé. La connexion électrique se fait par l'intermédiaire de vis métallique 52 dans les parties anode et cathode, au travers du bloc isolant.

Le dispositif décrit assure le refroidissement efficace des barrettes de puissance continue, grâce à une résistivité thermique faible, par exemple de l'ordre de 0,7°C/W pour un débit d'eau de l'ordre de 1 l/mn.

Par ailleurs, il est autonome puisqu'il assure le montage mécanique des barrettes entre elles sans la nécessité d'un support supplémentaire.

Enfin, ce dispositif présente l'avantage d'être modulaire, et il permet le montage d'un nombre de modules unitaires compris par exemple entre un et une dizaine.

## Revendications

1. Assemblage de N barrettes de diodes laser (4), dans lequel :
- chaque diode est montée à l'extrémité d'une embase (6) formant anode, traversée par un trou (10), l'ensemble des trous définissant un canal de circulation d'un fluide de refroidissement de l'assemblage linéaire de barrettes de diodes, chaque module (20, 22, 24, 26), constitué d'une barrette (4), de l'embase (6) et d'une cathode (14) correspondantes, étant séparé de chaque module immédiatement voisin par un joint plat (32, 34, 36, 38),
- chaque embase étant munie d'un second trou (12), l'ensemble des seconds trous étant aligné lorsque les barrettes sont disposées côte à côte en position de fonctionnement,
- deux brides (46, 48) de maintien étant disposées aux extrémités de l'assemblage linéaire de barrettes, ces brides étant serrées par une vis (42) qui traverse l'assemblage par l'ensemble des seconds trous.

2. Assemblage selon la revendication 1, la vis étant, à sa périphérie, recouverte d'une gaine isolante.

3. Assemblage selon l'une des revendications 1 ou 2, comportant des moyens (50) de connexion électrique pour l'alimentation des barrettes de diode.

4. Assemblage selon l'une des revendications 1 à 3, l'anode (6) associée à chaque barrette (4) étant reliée à la cathode (14) d'une barrette voisine.

## Patentansprüche

1. Baugruppe für N Laserdiodenreihen, bei der:
- jede Diode am Ende eines die Anode bildenden Sockels (6) angebracht ist, der ein Loch (10) aufweist, wobei die Gesamtheit der Löcher einen Kanal definiert, in dem ein Fluid zum Kühlen der linearen Diodenreihen-Baugruppe fließt, wobei jeder Modul (20, 22, 24, 26) durch eine Diodenreihe (4), den Sockel (6) und eine Kathode (14) gebildet wird und von jedem unmittelbar benachbarten Modul durch eine Dichtungsscheibe (32, 34, 36, 38) getrennt ist,
- jeder Sockel mit einem zweiten Loch (12) versehen ist und alle zweiten Löcher fluchten, wenn die Diodenreihen in Betriebsstellung Seite an Seite angeordnet sind,
- zwei Klemmflansche (46, 48) an den Enden der linearen Diodenreihen-Baugruppe angeordnet sind, wobei diese Flansche mittels einer Schraube (42), die die Baugruppe durch die Gesamtheit der zweiten Löcher hindurch durchquert, zusammengezogen werden.

2. Baugruppe nach Anspruch 1, wobei die Schraube auf ihrem Umfang mit einer isolierenden Umhüllung verkleidet ist.

3. Baugruppe nach einem der Ansprüche 1 oder 2, die elektrische Verbindungseinrichtungen (50) zur Versorgung der Diodenreihen umfaßt.

4. Baugruppe nach einem der Ansprüche 1 bis 3, wobei die jeder Diodenreihe (4) zugeordnete Anode (6) mit der Kathode (14) einer benachbarten Diodenreihe verbunden ist.

## Claims

1. Assembly of N laser diode arrays (4), wherein:
- each diode is assembled on the end of a base (6) forming an anode and traversed by a hole (10), all the holes defining a channel for the circulation of a fluid for cooling the linear assembly of diode arrays, each module (20, 22, 24, 26), constituted by an array (4), the base (6) and a cathode (14), being separated from each immediately adjacent module by a flat joint (32, 34, 36, 38),
- each base being provided with a second hole (12), all the second holes being aligned when the arrays are juxtaposed in the operating position,
- two holding flanges (46, 48) are placed at the ends of the linear assembly of arrays, said flanges being tightened by a screw (42), which passes through the assembly through all the second holes.

2. Assembly according to claim 1, the screw being peripherally covered by an insulating sheath.

3. Assembly according to one of the claims 1 or 2, having electrical means (50) for the supply of the diode arrays.

4. Assembly according to one of the claims 1 to 3, the anode (6) associated with each array (4) being connected to the cathode (14) of a neighbouring array.
